(19) Europäisches Patentamt
European Patent Office
Office européen des brevets

(11) Publication number: **0 398 917 B1**

(12) **EUROPEAN PATENT SPECIFICATION**

(45) Date of publication of patent specification: **15.09.93**

(51) Int. Cl.5: **C08G 8/36**, C08G 8/30, C08G 8/02

(21) Application number: **89901690.1**

(22) Date of filing: **21.11.88**

(86) International application number: **PCT/US88/04141**

(87) International publication number: **WO 89/05318 (15.06.89 89/13)**

(54) **ETHERS OF THE CONDENSATION PRODUCTS OF PHENOLDICYCLOPENTADIENE ADDUCTS AS THERMOSETTING RESINS.**

(30) Priority: **30.11.87 US 126378**
**30.11.87 US 126312**

(43) Date of publication of application: **28.11.90 Bulletin 90/48**

(45) Publication of the grant of the patent: **15.09.93 Bulletin 93/37**

(84) Designated Contracting States: **AT BE CH DE FR GB IT LI LU NL SE**

(56) References cited:
**US-A- 3 637 430**
**US-A- 4 120 847**
**US-A- 4 205 145**

**Chemicals Abstracts, vol.78, no.6, 12.02..1973,(Columbus, Ohio, US),Mori, Yoshhisuke et al:"Phenolic resins modified with cyclopentadiene and dicyclopentadiene", see page 37, abstract 30762c,& JP-A-72 31436**

(73) Proprietor: **ALLIED-SIGNAL INC. (a Delaware corporation)**
**Columbia Road and Park Avenue P.O. Box 2245R**
**Morristown New Jersey 07960(US)**

(72) Inventor: **ZUPANCIC, Joseph, J.**
**50 Algonquin Road**
**Des Plaines, IL 60017(US)**
Inventor: **FRECHET, Jean, M., J.**
**25 Fairview Drive**
**Ithica, NY 14850(US)**
Inventor: **CONRAD, Jeffrey, P.**
**50 E. Algonquin Road**
**Des Plaines, IL 60017(US)**
Inventor: **WREZEL, James, A.**
**681 Stanford Lane, Buffalo Grove**
**Illinois 60089(US)**
Inventor: **ZWEIG, Andrew, M.**
**50 East Algonquin Road**
**Des Plaines, IL 60017(US)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).



Rank Xerox (UK) Business Services
(3.10/3.6/3.3.1)

Chemicals Abstracts, vol 95, no.20, 16.11.1981,(Columbus,Ohio,US), Nippon Zeon Co., Ltd.:"Dicyclopentadiene-modified phenolic resins", see page 40, abstract 170330m, & JP-A-8186923

(74) Representative: **Brock, Peter William**
**UROUHART-DYKES & LORD 91 Wimpole Street**
**London W1M 8AH (GB)**

## Description

### BACKGROUND OF THE INVENTION

The subject matter of this application is directed toward resins used in the manufacture of reinforced plastics. More particularly, the resins (binders) are used in the preparation of composites formed from fibers embedded in a polymer resin matrix.

To overcome some mechanical and structural limitations of plastics it has become relatively commonplace to reinforce them with other components. Composites formed of various fibers embedded in a polymer resin matrix are especially useful and susceptible to enormous variation depending upon the nature of the fiber used, how the fiber is utilized, and the matrix or binder for the fibers. Materials which have been used as fibers include glass, quartz, oriented polymers such as the aramids (Kevlar™), graphite and boron. Whatever their composition such fibers can be used as chopped or continuous filaments, and when used as continuous filaments they can all be unidirectional or woven into a fabric. The matrix can be, for example, a polyester, epoxy, polyimide, polyetherketone or polyetherimide resin as either a thermoset or thermoplastic material. The uses for such composites range from airframes to tennis rackets and from boat hulls to rocket motor casings.

A particular area of composite application is that of printed circuit boards, especially multilayer circuit boards, for mounting electronic components. The use of glass fabric as the reinforcing material has become more-or-less standard and epoxy resins are most often used as the matrix. For the fiber to exert a reinforcing action it is necessary that the fibers be completely coated with resin, and to achieve this the glass fiber often is surface treated to provide sites for chemical bonding to the resin or to its precursor or for otherwise improved adhesion to the matrix material.

Multilayer circuit boards are laminates with alternating layers of composite and etched copper sheet. A brief discussion of their manufacture will aid in appreciating the properties requisite for such boards. A woven glass fabric is first impregnated with resin by dipping the cloth in a resin solution, often referred to as the varnish solution, in what is called the A-stage. Solvent is then removed to afford a glass cloth reinforced resin, or prepreg, in what is called the B-stage. In some cases the resin in the prepreg may be partially cured, in other cases uncured, but in all cases the prepreg is a non-tacky, readily handled rigid sheet of glass cloth embedded in and coated with a resin. The finished circuit board is prepared by laminating alternating layers of prepreg and etched copper foil under conditions of temperature and pressure where resin is cured, i.e., further polymerized and crosslinked to a final infusible, insoluble stage (C-stage).

From the above brief description some necessary and desirable characteristics of the resin may be readily discerned. The circuit board will be subjected to soldering temperatures and may be operated at an elevated temperature, or experience cyclic locally elevated temperatures because of local power generation, and thus the thermal coefficient of expansion of the resin should approximate that of glass to ensure continued dimensional stability and resistance to heat distortion. The resin should have a high solubility in the varnish solution to ensure high resin loading. The varnish solution should have a sufficiently low viscosity for even coating but not too low a viscosity as to run off the fibers. It is necessary that the prepreg not be tacky so that it can be readily handled and stored. The resin is desirably noncrystalline for enhanced solubility in the varnish solution and for good film forming properties in the prepreg. The resin should have adequate flow at the C-stage so as to make void-free laminated bonds, with the curing temperature somewhat higher than the glass transition temperature ($T_g$) of the resin to afford a wider processing "window." The resin also should be chemically resistant to a corrosive environment and to water vapor. To ensure that the discrete electrical components on a circuit board interact only via the etched path on the copper foil, it is desirable that the matrix have a low dielectric constant and high resistance.

The invention to be described is an amorphous, thermosetting resin which affords a varnish solution of high solids content with a viscosity leading to even coating without runoff, which affords a non-tacky prepreg, has a glass transition temperature sufficiently below the curing temperature to afford an adequate window of processing, and which shows excellent flow properties at the C-stage. The final cured resin exhibits a low dielectric constant and dissipation factor, a low coefficient of thermal expansion, and a high glass transition temperature. In short, we believe our cured resin has properties superior to those currently recognized as industry standards in the lamination of circuit boards, and thus presents outstanding benefits.

It needs to be emphasized that although this application will stress the utilization of the resins of our invention in the production of multilayer circuit boards, the resins may be useful in fabricating composites generally. Consequently, it needs to be explicitly recognized that the resins of our invention are intended for composite manufacture without any limitations other than those imposed by the product specifications

themselves.

## SUMMARY OF THE INVENTION

The purpose of our invention is to provide thermosetting resins whose properties make them desirable in the preparation of composites, especially in laminated multilayer boards of a glass fiber in a polymer matrix. An embodiment comprises ethers of the condensation product of phenol-dicyclopentadiene adducts, optionally with certain aldehydes and ketones. In a specific embodiment the ether is a vinylbenzyl ether and particularly a paravinyl benzyl ether. In a more specific embodiment the ether is a mixture of vinylbenzyl and alkyl ethers in a ratio of at least 1:1. In a still more specific embodiment at least 80% of the phenolic groups of the product have been converted to the ether. In a yet more specific embodiment the phenol is a cresol. In yet another embodiment the aldehyde is formaldehyde. Other embodiments will be apparent from the following description.

## DESCRIPTION OF THE INVENTION

Our invention is a class of thermosetting resins of a vinylbenzyl ether of a dicyclopentadiene-phenol adduct optionally condensed with certain aldehydes and ketones. In the detailed description which follows we shall first describe the dicyclopentadiene-phenol adducts, the condensation product of these adducts and suitable aldehydes and ketones, and then the ethers of the condensation products. Such a descriptive sequence in fact tracks the preparative route employed for the resins, but it is not intended to imply that such a sequence is mandatory or unique.

The dicyclopentadiene-phenol reaction products, which are adducts or oligomers of a dicyclopentadiene and a phenol, are described in U.S. Patents 3,305,522 and 3,751,375; compare 3,036,138. Such products result from the reaction of a dicyclopentadiene with at least one molar proportion of a phenolic compound in the presence of a Friedel-Craft type catalyst, and in particular the more potent Friedel-Craft catalysts such as aluminum chloride, zinc chloride, ferrous and ferric chloride and boron trifluoride, as well as complexes based on boron trifluoride. The reaction is conducted at a temperature from 25 to 160°C preferably between 80 and 150°C. The molar ratio of phenolic compound to dicyclopentadiene employed in the reaction mixture can be varied from 1:1 to at least 5:1 with higher ratios possible but without any beneficial effects. The proportions usually employed range from about 1 to about 4 molar proportions of phenolic compounds per mole of dicyclopentadiene. Over most of this range the proportions of reactants provide for a substantial excess of the phenolic compounds beyond that which will actually react with the dicyclopentadiene. The molar proportions of phenolic compounds which read with dicyclopentadiene usually varies from 1 to 2, with the preferred molar proportion of phenol ranging from 1.5 to 1.75. In some instances it may be desirable to carry out the reaction in an inert organic solvent such as benzene or toluene.

The adducts described above, I, have essentially the formula,

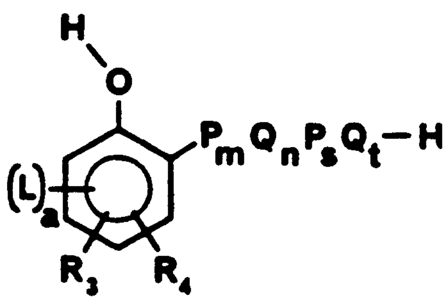

where

P = 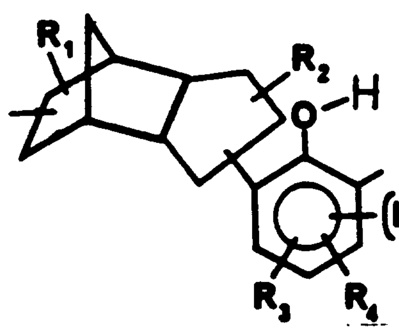 ; Q = 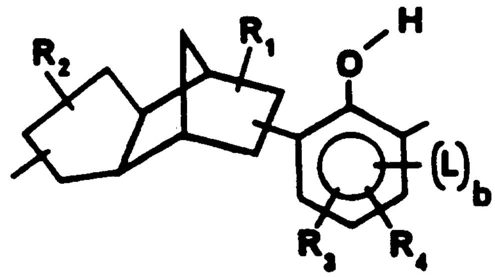

with

$R_1$,$R_2$ = H or alkyl of 1-10 carbon atoms;
$R_3$ = H, alkyl of 1-20 carbon atoms, alkoxy, halogen or aryl;
$R_4$ = H or tert-butyl;
L = Br or Cl;
a = 0, 1, or 2;
b = 0 or 1;
m, n, s, and t are 0 or an integer, and $m+n+s+t=z$ is an ingeger from 1-10.

The dicyclopentadiene portion can be substituted in either ring. $R_1$ and $R_2$ usually are hydrogen, that is, an unsubstituted dicyclopentadiene is preferred in the practice of this invention, but each of $R_1$ and $R_2$ can be an alkyl group, preferably a primary alkyl group, containing up to 10 carbon atoms. The lower alkyl groups, such as methyl, ethyl, propyl, and butyl, are especially preferred where the dicyclopentadiene is substituted. Substitution can be at any position of the dicyclopentadiene ring system but it is preferred that $R_1$ be at a carbon of the 5-member ring not bonded to the aryl group, and that $R_2$ is at the bridge or bridgehead carbon of the bicyclic ring portion.

The phenolic termini of our resins as well as the phenolic portion of P or Q may be substituted by a saturated hydrocarbon group, a halogen atom, or an alkoxy group. For the condensation with dicyclopentadiene mixtures of such phenols also may be used. Thus, $R_3$ may be an alkyl group containing 1 to 20 carbon atoms, and those containing up to 10 carbon atoms are preferred in the practice of this invention. Alkyl groups may be primary, secondary, or tertiary. Examples of alkyl groups which may be used in the practice of this invention include methyl, ethyl, propyl, butyl, pentyl, hexyl, heptyl, octyl, nonyl, decyl, undecyl, dodecyl, tridecyl, tetradecyl, pentadecyl, hexadecyl, heptadecyl, octadecyl, nonadecyl, and eicosyl, with the methyl, ethyl, propyl, and butyl groups, particularly the methyl moiety, being favored. The moiety $R_3$ also may be an aryl group, including substituted aryl groups, especially where the substituent is a lower alkyl group containing up to about 4 carbon atoms. Examples of suitable aryl groups include phenyl, methylphenyl, ethylphenyl, propylphenyl, butylphenyl, naphthyl. As previously mentioned, the moiety $R_3$ also may be a halogen atom or an alkoxy group. The phenol also may be unsubstituted, i.e., $R_3$ = H. Where a substituent is present it is at a position meta or para to the position bearing the oxygen atom. In fact, a mixture of meta- and para-substituted phenols are preferred in the practice of this invention because such a mixture tends to afford an amorphous resin, which is a beneficial feature, and the case where a mixture of meta- and para-cresols are used to prepare the adduct ($R_3$ = m-$CH_3$ and p-$CH_3$) is especially preferred.

The phenolic termini of our resins and the phenolic portion of P or Q also may be substituted by a group, $R_4$, which is hydrogen or a tertiary butyl moiety. In a preferred embodiment of this invention $R_3$ is a lower alkyl group containing up to 4 carbon atoms and at least 5 percent of all $R_4$ are tert-butyl, and it is even more desirable that up to 25 percent be tert-butyl. In a yet more preferred embodiment, at least 5 percent of all $R_4$ are tert-butyl and $R_3$ is a methyl group, with the variant where up to 25 percent of $R_4$ are tert-butyl being especially preferred, i.e., $R_4$ is H or a tert-butyl group. The methyl group, $CH_3$, is at a position meta or para to the position bearing the oxygen atom. In fact, a mixture of meta- and para-cresols are preferred in the practice of this invention because such a mixture tends to afford an amorphous resin, which is a beneficial feature.

The basic resins also can be readily modified to be flame retardant by incorporating halogen atoms into the aromatic rings. L may be especially bromine, and where the aromatic ring is halogenated a is 0, 1 or 2

and b is 0 or 1. Polyhalogenated materials are desired as flame retardants, which means that a and b are recommended to be maximized. Where the aromatic rings are not halogen substituted then both a and b are 0.

The fragments P and Q are subunits of the adduct. Where the adduct is an oligomer it may be a head-to-head, head-to-tail, or completely or partially random arrangement. Where oligomers are formed they are of relatively low molecular weight. The variables m, n, s, and t each are integers such that z, where z equals m + n + s + t, is an integer from 1 to 10, and usually is up to 5, with z being 1 or 2 preferred in the practice of our invention. The arrangement of the polymeric subunits may be exemplified by the following. Where all the subunits are the same, n = s = t = 0. Where the subunits alternate, the two simplest cases are m = n = 1 and s = t = 0, or n = s = 1 and m = t = 0.

The phenol-dicyclopentadiene adducts I may be then reacted with certain aldehydes and ketones to afford a condensation product, II. The reaction occurring is analogous to the well known phenol-formaldehyde condensation to form phenol-formaldehyde resins. In its simplest form this condensation may be represented by the reaction,

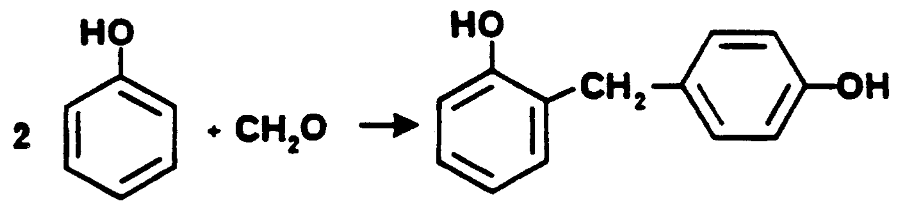

There are many phenolic residues in our adducts available to react or condense with aldehydes and ketones, and therefore a multitude of structurally analogous products may result differing both in the site of the condensation reaction as well as the number of phenolic residues per adduct participating in the condensation reaction. Nonetheless, all of the condensation products are considered within the scope of our invention. Generally the molar ratio of the adduct to the monoaldehyde or ketone with which it is reacted is approximately 2:1, and most usually is not greater than 3:1. This molar ratio itself is a limitation on the number of products formed, although the number still remains large.

Of the aldehydes used in the condensation with the phenol-dicyclopentadiene, adducts I formaldehyde is by far the most important one. Saturated aliphatic aldehydes of formula $C_rH_{2r-1}CHO$ where r is an integer from 1 to 9, and especially from 1 to 5, also may be used in the practice of this invention. Branched alkyl chains in the foregoing aldehydes may be used up to r = 5, but unbranched chains are preferred thereafter. Benzaldehyde and substituted benzaldehyde also may be used in the practice of this invention.

Where ketones are used in a condensation reaction with the foregoing adducts the ketones are of the formula $CH_3COZ$, where Z is an alkyl or aryl group, and more particularly an alkyl group containing from 1 to 4 carbons. The most commonly employed aryl group will be the parent phenyl group and its substituted analogs. However, more complex aryl groups, such as naphthyl, anthryl also may be employed.

Dialdehydes also are usable to afford oligomeric condensation products which result from the reaction of 1 molar proportion of selected dialdehydes with from 3 to about 4 molar proportions of the adduct. Although more than 4 molar proportions of the adduct can be used in the practice of this invention, no practical benefit appears to result therefrom. The dialdehydes which may be used are the linear, terminal alkalene dialdehydes of formula $OHC(CH_2)_xCHO$ where x is 0 or an integer from 1 to 6. Such dialdehydes include glyoxal, malondialdehyde, succindialdehyde, glutaraldehyde, adipaldehyde, pimelaldehyde, and sebacaldehyde. Those aldehydes where x is 0-4 are particularly preferred and glyoxal (x = 0) is especially favored in the practice of this invention.

Although generally only a single aldehyde or ketone will be used in the condensation with the the adducts I, nonetheless it is possible to use any combination of the aldehydes and ketones given. This leads to condensation products of even greater structural complexity which may be advantageous, at least in selected cases.

The preparation of the condensation products of phenols and aldehydes is well known and need not be described here in great detail. Quite generally, such a condensation is known to be catalyzed by acids generally and Bronsted acids particularly. The particular nature of the Bronsted acid used is not an important feature, and often it is particularly convenient to utilize a strong acid, such as sulfuric acid. Organic sulfonic acids, especially p-toluene sulfonic acid, methane sulfone acid, and trifluoromethyl sulfonic acid, form one general class of strong Bronsted acids usable in the condensation, although other strong

acids bearing one or more strongly electron withdrawing groups in close proximity to the carboxyl moiety also are usable. Some examples of the latter include dichloroacetic acid, trichloroacetic acid, difluoroacetic acid, and trifluoroacetic acid.

The phenolic hydroxyls in the phenol-dicyclopentadiene adducts I or the condensation product II described above then are capped so as to be converted to ethers, III. At least 80% of the phenolic groups are so capped, and it is desirable that at least 90%, and even more desirable that at least 95%, of the phenolic groups be capped by replacement of the phenolic hydrogens with a group Y. Stated differently, in the formula above less than 20% of the phenolic hydrogens remain, and desirably less than 10%, even more desirably less than 5%, are present.

The best case results where the ether portion, Y, is a vinylbenzyl moiety, that is, of the structure

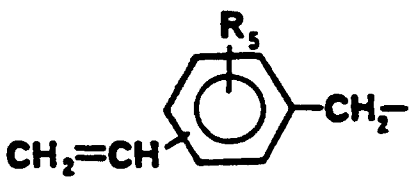

where the vinyl group is either meta or para to the $CH_2$, where $R_5$ is hydrogen, and which usually is a mixture of the meta- and para-isomers. $R_5$ is a chemically inert substituent selected from hydrogen, alkyl moieties containing from 1 to 10 carbon atoms, the halogens, alkoxy moieties containing from 1 to 10 carbon atoms, and monovalent aromatic hydrocarbon radicals As previously indicated $R_5$ usually is hydrogen.

However desirable it may be to have all the phenolic hydroxyls end-capped with vinylbenzyl moieties, there is a decided cost advantage when fewer than all of the other groups are vinylbenzyl, usually at the expense of a somewhat lower dielectric constant. In our invention it is required that at least 50% of the Y moieties be a vinylbenzyl moiety, but a product with better performance characteristics resuits when from 70 to 100% of the ether groups are vinylbenzyl, and the best product results when 95 to 100% of such groups are vinylbenzyl.

In those cases where less than all of the ether groups are vinylbenzyl, then we are partial to resins where the ether portion Y is an alkyl group containing from 1 to 10 carbons, a cycloalkyl group having 5 to 10 carbons, or a benzyl group. Where Y is an alkyl group, the primary alkyl groups are given priority, especially the primary lower alkyl groups containing from 1 to 4 carbon atoms. Thus, the most desirable alkyl groups consist of methyl, ethyl, 1-propyl, 1-butyl, and 2-methyl-1-propyl. Other alkyl groups are represented by 1-pentyl, 1-hexyl, 1-heptyl, 1-octyl, 1-nonyl, 1-decyl, 2-methyl-1-butyl, 3-methyl-1-butyl, 2,3-dimethyl-1-butyl, 3,3-dimethyl-1-butyl, 2-methyl-1-pentyl, However, it is to be emphasized that a benzyl group also operates quite satisfactorily in the ` practice of our invention. The most common cycloalkyl groups used in our invention are 5- and 6-membered cycloalkanes, unsubstituted or alkyl substituted so as to contain 5 to 10 carbon atoms. Examples are cyclopentyl, cyclohexyl, methylcyclopentyl, dimethylcyclopentyl, ethylcyclopentyl, propylcyclopentyl, butylcyclopentyl, pentylcyclopentyl, ethylmethylcyclopentyl, methylpropylcyclopentyl, butylmethylcyclopentyl, methylcyclohexyl, dimethylcyclohexyl, ethylcyclohexyl, propylcyclohexyl, butylcyclohexyl. The 1-propyl group is an especially desirable alternative to the vinylbenzyl moiety, and resins where less than 5% of the phenolic hydrogens remain with the ether moieties being vinylbenzyl or 1-propyl in a ratio from 1.1:1 to 6:1 are highly recommended.

The ethers of this invention may be prepared by any convenient method known in the art. However, they are most readily prepared by reacting a vinylbenzyl halide with the aldehyde/ketone condensation product of the dicyclopentadiene-phenol adduct in a basic solution. Generally a mixture of the meta- and para-isomers of vinylbenzyl chloride are used, although the bromide and, to a lesser extent, the iodide also may be used. The reaction may be conveniently performed in an alcoholic potassium hydroxide solution, often containing acetone, N-methylpyrrolidone, or some other organic cosolvent, at the reflux temperature. Where some of the ether moieties are alkyl, cycloalkyl, or benzyl moieties these may be prepared by reacting a suitable alkyl, cycloalkyl, or benzyl halide with a partially vinylbenzyl end-capped adduct, or by reacting the uncapped adduct with a mixture of halides.

A mixture of thermosetting resins of the foregoing description frequently is used in the preparation of composites. The use of a mixture tends to promote formation of an amorphous resin which is desirable both in increasing the solubility of the resin in a varnish solution, in promoting good film-forming qualities, and in providing a stable, non-flaking coating in the prepreg stage. A desirable mixture of resins III is one which

arises from a mixture of adducts I having 15 to 40% by weight of I where $z = 1$, 10 to 30% with $z = 2$, 5 to 20% with $z = 3$, 5 to 20% with $z = 4$, and 5 to 20% with $z = 5$-10.

The appended vinyl groups are readily crosslinked in a curing step effected by thermal, chemical, or radiative means. Thermal curing is generally done in the temperature range between about 110 and about 250°C, and in practice multilayer boards may be laminated at a temperature between about 150 and about 200°C for 0.5-5 hours with post curing at about 180-250°C for about 0.5-24 hours. Curing also may be brought about using a free radical initiator, such as azo-bis-isobutyronitrile, benzoyl peroxide, di-t-butyl peroxide, etc. Curing may be effected as well by irradiation, especially by visible and ultraviolet light in the presence of a suitable photoinitiator. Whether thermal, chemical, or photochemical curing is performed, the resin becomes extensively crosslinked and sets to an infusible, insoluble glassy solid.

The materials of our invention also can be blended with other types of vinylbenzyl ethers of functionality greater than or equal to 2 to provide A-stage varnish solutions with tailorable viscosity and variable properties in the cured product such as glass transition temperature, heat distortion temperature, fracture toughness. For example, our resins could be blended with various vinyl benzyl bisphenols or styrenated bisphenols to raise crosslink density and improve processability of the bis-styryl compound. The materials of our invention are polymers of moderate functionality (i.e., number of-vinylbenzyl groups per molecule) and viscosity and they can be incorporated to reduce crystallinity of various styrenated bisphenols where the bisphenols are exemplified by the formula

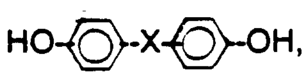

with X being -O-, $-C(CH_3)_2$;$-SO_2$, -O-, -CO.-, raise the resin solids content in the A-stage varnish solution, to raise the resin content in the B-stage, and to reduce the amount of resin flow in the C-stage. High-to-moderate molecular weight poly(vinylbenzyl ethers) also may be useful for improving the shelf life of other styrenated oligomers, and may raise the ductility of the otherwise brittle laminate, such as in the case of styrenated bisphenol A. Our materials also can be blended with various halogenated resins to obtain, after curing, a polymer with increased flame retardancy.

The following examples are only illustrative of this invention. Materials used therein are to be construed as only representative of those which can be used in the practice of our invention, and are not a limitation of the invention as claimed.

EXAMPLE I

**Preparation of resin.** Cresol-dicyclopentadiene adducts resulting from the reaction of different molar proportions of cresol were obtained from Goodyear Rubber Company. The synthesis of the p-vinylbenzyl ether of the adduct resulting from 3 molar proportions of cresol as described below in detail is representative of the synthesis of other ether-capped resins.

To 100 g (0.50 moles phenolic hydroxyls) of a cresoldicyclopentadiene adduct was added 0.60 moles of vinylbenzyl chloride as a 60/40 mixture of meta/para isomers. Acetone (220 mL) was added and the solution was heated to reflux. To this was added dropwise 76 mL of a 31% methanolic potassium hydroxide solution (0.50 moles KOH) over a period of 1 hour. The reaction mixture was stirred at ambient temperature for 18 hours, then heated at reflux for an additional two hours. After the mixture was cooled, an additional 200 mL acetone was added and the mixture was stirred overnight. Anhydrous magnesium sulfate was added to desiccate the solution, and after 2 hours solids were removed by filtration. The filtered solution was added to ca.4 L cold methanol to precipitate the ether and the solid was collected by filtration. Solid was washed with methanol and vacuum dried to give 97.5 g of a beige powdery solid. Some properties of two typical resins are summarized in Table 1.

**TABLE 1** - Properties of Adducts and Uncured Resins

| Material | $M_n$ [a] | $M_w$ [b] | $M_w/M_n$ | <f> [c] |
|---|---|---|---|---|
| 3:1 adduct | 515 | 636 | 1.2 | 2.4 |
| Adduct-ether | 854 | 1089 | 1.3 | |
| 3:2 adduct | 793 | 1202 | 1.5 | 3.9 |
| Adduct-ether | 1262 | 1716 | 1.4 | |

a. Number-average molecular weight by gel permeation chromatography.

b. Weight-average molecular weight by gel permeation chromatography.

c. Average number of hydroxyl groups per molecule. Note that <z>=<f>-1.0.

**TABLE 2 - Properties of Uncured Resin**

| Resin Source | $T_m$[a] onset, °C | $T_m$[b] peak, °C | $H_p$[c] | $T_p$[d], °C |
|---|---|---|---|---|
| 3:1 adduct | 43 | 48 | 79 | 140 |
| 3:2 adduct | 73 | 83 | 65 | 130 |

a. Onset of melting
b. Peak melting
c. Heat of polymerization in joules per gram.
d. Heat of polymerization peak temperature.

EXAMPLE II

**Preparation of crosslinked polymer; thermal curing.** The resins prepared as described above were thermally cured from a chloroformtoluene solution using a cycle of 100°C for 16 hours, 120°C for 2 hours, 160°C for 18 hours, 200°C for 3.5 hours, and 225°C for 1 hour. Some properties of the resulting cured resin are summarized in Table 3.

**TABLE 3 - Properties of Cured Resin**

| Resin Origin | DSC[a] | | TMA[b] | | | |
|---|---|---|---|---|---|---|
| | $T_g$[c] | SP[d] | $\overline{\alpha_g}$[e] | $\overline{\alpha_{260}}$[f] | E[g] | $\epsilon'/\tan\delta$[h] |
| 3:1 adduct | >260 | 186 | 65 | 103 | 2.8 | 0.006 |
| 3:2 adduct | >260 | 230 | 35 | 55 | 2.8 | 0.006 |
| 50:50 Blend of 3:1 adduct and styrenated tetrabromo bisphenol A | >290 | -- | -- | 57 | 2.6 | 0.006 |

a. Differential scanning calorimetry.
b. Thermomechanical analysis.
c. Glass transition temperature.
d. Softening point.
e. Thermal expansivity to softening point, ppm/°C.
f. Thermal expansivity to 260°C, ppm/°C.
g. Dielectric constant measured at 1 MHz, 23°C, 0% relative humidity.
h. Dissipation factor measured under above conditions.

EXAMPLE III

**Synthesis of styrene-terminated t-Butyl-p-cresol Dicyclopentadiene.** To a 5L three-necked round bottom flask fitted with a mechanical stirring shaft and charged with 2L of 1-methyl-2-pyrrolidinone, 4.55 g

of BHT, and 500.0 g of t-butyl-p-cresol dicyclopentadiene ($M_n$ = 560, $M_w$ = 727, dispersity = 1.30) was added 236.58 g of vinylbenzyl chloride. A reflux condensor, a pressure equalizing dropping funnel, and a heated water bath were brought into place. The mixture was placed under $N_2$ and brought to 60°C with stirring. 215 mL of an approximately 9 molal solution of potassium hydroxide in methanol was added dropwise over 30 minutes. The mixture was kept at 60°C for an additional 3.5 hours. 88.98 g of 1-bromopropane was then added followed by 85 ml of the 9 molal KOH/MeOH which was again added dropwise over 30 minutes. The reaction mixture was kept at 60°C for an additional 3.5 hours then allowed to cool to room temperature. 2.3 L of toluene were added and the mixture transferred to a separatory funnel and washed with 4 x 5.7 L of water. The organic phase was dried over $Na_2SO_4$, slurried with Celite and filtered through a glass frit. Solvent was removed by rotary evaporation leaving a brown resin $M_n$ = 657, $M_w$ = 800, dispersity 1.29. Samples are identified as follows:

A = Neat resin coating

B = Cast from toluene.

**TABLE 4 - Cured Resin Properties**

| Sample | $Tg(^{o}C)^{a}$ DSC | $Tsp(^{o}C)^{b}$ TMA | $\overline{\alpha_g}^{e}$ $(ppm/^{o}C)$ | $\overline{\alpha_{260}}^{f}$ $(ppm/^{o}C)$ | $\epsilon'/\tan\delta$ [e] 0%RH[f] | $\epsilon'/\tan\delta$ [e] 50%RH | $H2O^{g}$ absorption (wt%) |
|---|---|---|---|---|---|---|---|
| A | >300 | 107 | 41 | 129 | 2.66/.057 | 2.64/.006 | .054 |
| B | >300 | 121 | 58 | 135 | 2.68/.046 | 2.73/.012 | -- |

a. Glass transition temperature.

b. Softening point.

c. Coefficient of thermal expansion from 25°C to Tsp.

d. Coefficient of thermal expansion from 25°C to 260°C

e. $\epsilon'$ is the dielectric constant, $\tan\delta$ the dissipation factor, measured at 1 MHz, 25°C, two-fluid cell.

f. Relative humidity.

g. Weight gain after two weeks at 50% relative humidity.

TABLE 5

| Resin Properties | | | |
|---|---|---|---|
| T onset (°C) | T peak (°C) | Total H (J/G) | Gel Time @ 170°C (sec) |
| 161 | 207 | 143 | 1350 |

EXAMPLE IV

Spectroscopic analysis of the product from the previous example indicated the presence of a small amount of residual hydroxyl groups. Material prepared as in that example was alkylated further to completely cap all hydroxyl functionality by the following method. 200.0 g of styrene terminated-alkylated t-butyl p-cresol dicyclopentadiene prepared as in Example III was dissolved in 550 ml of 1-methyl-2-pyrrolidinone and added to a 1 liter 3-neck round bottom flask. The flask was then charged with 26.25 ml of 1-bromopropane and 127 g of BHT. A reflux condensor, a stir bar and a pressure equalizing dropping funnel were brought into place and the flask placed in a 60°C water bath. 45 ml of an approximately 9 molal solution of KOH in methanol was added dropwise with stirring over 30 minutes. The reaction was maintained at 60°C for an additional 5.5 hours and then allowed to cool to room temperature. 600 ml of toluene was added and the product washed with 4 x 1.5 l of water. The organic phase was dried over $Na_2SO_4$, slurried with celite and filtered through a glass frit. Solvent was removed by rotary evaporation leaving a brown resin ($M_n$ = 626, $M_w$ = 850, dispersity 1.36).

Samples were cured by heating at 80°C for 2 hours, 100°C for 16 hours, 120°C for 4 hours, 160°C for 16 hours, 200°C for 4 hours and then 225°C for 1 hour. Samples are identified as follows:

A = Neat resin coating without solvent
B = Cast from acetone
C = Neat resin casting without solvent
D = Cast from toluene

**TABLE 6 - Cured Resin Properties**

| Sample | Tg(°C)[a] DSC | Tsp(°C)[b] TMA | $\alpha_g$[e] (ppm/°C) | $\alpha_{260}$[f] (ppm/°C) | ε'tanδ[e] 0%RH[f] | ε'tanδ[e] 50%RH | H2O[g] absorption (wt%) |
|---|---|---|---|---|---|---|---|
| A | >300 | 132±6 | 69±4 | 122±4 | 2.50/.254 | 2.735/0.027 | 0.075 |
| B | >300 | 125±6 | 77±5 | 123±6 | 2.58/0.010 | 2.68/0.014 | 0.025 |
| C | >300 | 136±2 | 85±2 | 129±4 | 2.59/0.009 | 2.61/0.048 | 0.053 |
| D | >300 | 127±5 | 79±4 | 139±5 | 2.61/0.011 | 2.61/0.042 | 0.050 |

a. Glass transition temperature.

b. Softening point.

c. Coefficient of thermal expansion from 25°C to Tsp.

d. Coefficient of thermal expansion from 25°C to 260°C

e. ε' is the dielectric constant, tanδ the dissipation factor, measured at 1 MHz, 25°C, two-fluid cell.

f. Relative humidity.

g. Weight gain after two weeks at 50% relative humidity.

TABLE 7

| Resin Properties | | | |
|---|---|---|---|
| $T_{onset}$a (°C) | $T_{peak}$b (°C) | Total$\Delta H^c$ (J/g) | Gel Time @ 170°C (sec) |
| 161 | 207 | 143 | 1350 |

a. Onset of polymeriazation
b. Peak polymerization temperature
c. Total enthalpy of polymerization

c. TABLE 8

| Prepreg Properties[a] | | | |
|---|---|---|---|
| T(°C) | Time | Resin Flow | Appearance |
| 150 | 5 | + | good |

a) 108/256 vinylsiilane glass

EXAMPLE V

In this example, copolymers of styrene-terminated t-butyl-p-cresol dicyclopentadiene (STBCDP) prepared according to Example III above and styrene-terminated bromo-substituted tetrakisphenolethane (STBTPE) containing 70% vinylbenzyl, 30% propyl groups, were prepared utilizing the curing procedure hereinbefore set forth in the above examples using toluene as the solvent. Analysis of these blends disclosed the following properties which are set forth in Table 9 below.

TABLE 9

| STBCDP wt(g) | STBTPE wt(g) | Tg($^{o}$C)[a] DSC | Tsp($^{o}$C)[b] TMA | $\bar{\alpha}_g$[e] (ppm/$^{o}$C) | $\bar{\alpha}_{260}$[f] (ppm/$^{o}$C) | ε'/tanδ[e] 0%RH[f] | ε'/tanδ[e] 50%RH | $H_2O$[g] absorption (wt%) |
|---|---|---|---|---|---|---|---|---|
| 11.85 | 11.85 | >300 | 107 | 73 | 148 | 2.56/0.014 | 2.79/0.005 | 0.093 |
| 20.54 | 6.84 | >300 | 123 | 62 | 147 | 2.69/0.005 | 2.71/0.006 | 0.082 |

a. Glass transition temperature.
b. Softening point.
c. Coefficient of thermal expansion from 25$^{o}$C to Tsp.
d. Coefficient of thermal expansion from 25$^{o}$C to 260$^{o}$C
e. ε' is the dielectric constant, tanδ the dissipation factor, measured at 1 MHz, 25$^{o}$C, two-fluid cell.
f. Relative humidity.
g. Weight gain after two weeks at 50% relative humidity.

EXAMPLE VI

In a similar manner m-cresol dicyclopentadiene ($M_n$ = 242, $M_w$ = 488, dispersity 2.02) was reacted first with vinylbenzyl chloride in the presence of KOH followed by 1-bromopropane in the presence of KOH. This material was again found to have small amounts of residual hydroxyl groups. The resin was

redissolved and again reacted with 1-bromopropane in the presence of KOH. The product was isolated as described in Examples I and III, $M_n$ = 292, $M_w$ = 572 and dispersity 1.96. The resin was cured as described in Example II above.

**TABLE 10 - Cured Resin Properties**

| Sample | $Tg(^{o}C)^{a}$ DSC | $Tsp(^{o}C)^{b}$ TMA | $\overline{\alpha}_g{}^{e}$ (ppm/°C) | $\overline{\alpha}_{260}{}^{f}$ (ppm/°C) | $\epsilon'/\tan\delta^{e}$ 0%RH[f] | $\epsilon'/\tan\delta^{e}$ 50%RH | $H2O^{g}$ absorption (wt%) |
|---|---|---|---|---|---|---|---|
| 5461-107 | 141 | 123 | 64 | 137 | 2.66/.014 | 2.69/.020 | .05 |

TABLE 11

| Resin Properties | | | |
|---|---|---|---|
| T onset (°C) | T peak (°C) | Total H (J/G) | Gel Time @ 170°C (sec) |
| 143 | 191 | 100 | 77 |

EXAMPLE VII

In this example, copolymers of styrene-terminated t-butyl-p-cresol dicyclopentadiene (STBCDP) prepared according to Example III above and styrene-terminated bromo-substituted tetrakisphenol (STBTPE), containing 70% vinylbenzyl, 30% propyl groups, were prepared utilizing the curing procedure described in the above examples using toluene as the solvent. Analysis of these blends disclosed the following properties.

**TABLE 12 - Properties of STBCDP - STBTPE Copolymers**

| STBCDP wt(g) | STBTPE wt(g) | $Tg(^{o}C)^{a}$ DSC | $Tsp(^{o}C)^{b}$ TMA | $\overline{\alpha}_g{}^{e}$ ($ppm/^{o}C$) | $\overline{\alpha}_{260}{}^{f}$ ($ppm/^{o}C$) | ε'tanδ [e] 0%RH[f] | ε'tanδ [e] 50%RH | $H2O^{g}$ absorption (wt%) |
|---|---|---|---|---|---|---|---|---|
| 9.6483 | 9.7003 | >300 | 150 | 59 | 117 | 2.82/0.0012 | 2.82/0.0003 | 0.106 |
| 14.8427 | 4.8804 | >300 | 143 | 62 | 115 | 2.75/0.0012 | 2.75/0.0008 | 0.097 |

a. Glass transition temperature.
b. Softening point.
c. Coefficient of thermal expansion from $25^{o}C$ to Tsp.
d. Coefficient of thermal expansion from $25^{o}C$ to $260^{o}C$
e. ε' is the dielectric constant, tanδ the dissipation factor, measured at 1 MHz, $25^{o}C$, two-fluid cell.
f. Relative humidity.
g. Weight gain after two weeks at 50% relative humidity.

EXAMPLE VIII

*Styrene termination-alkylation of m-cresol-dicyclopentadieneformaldehyde. (70% Vinylbenzyl/30% propyl) (STCDPF (70 VBz/30 Pr)).* To a 2 liter three necked round bottom flak fitted

with mechanical stirring shaft, reflux condenser and pressure equalizing dropping funnel was charged 320 mL of 1-methyl-2-pyrrolidinone, 0.68g of BHT, 125.0g of m-cresol-dicyclopentadiene-formaldehyde (obtained from Borden Chemical Co.) ($M_n$ = 604, $M_w$ = 2970 and dispersity 4.92) and 82.34g of vinylbenzylchloride. The reaction solution was brought to 60°C with stirring with the aid of a water bath and then 80 mL of an -9 molal solution of KOH in methanol was added dropwise over a 30 minute interval. The mixture was maintained at 60°C with stirring for an additional 4.5 hours. 44.24g of 1-bromopropane in 200 mL of 1-methyl-2-pyrrolidinone was added to the reaction solution. 50 mL of -9 molal KOH in methanol was then added dropwise over 30 minutes. The reaction was kept at 60°C an additional 100 minutes and then allowed to cool to room temperature. 350 mL of toluene was added to the reaction mixture and the mixture transferred to a separatory funnel and washed with 3 x 900 mL of water. The organic phase was dried over sodium sulfate, slurried with celite and filtered through a glass frit, and the resin was isolated by removal of the solvent under vacuum ($M_n$ = 674, $M_w$ = 3040, dispersity 4.51).

The resin demonstrated the following properties: $T_{polymerization}$ (onset), 102°C; $T_{polymerization}$ (peak), 151°C; $H_{polymerization}$, 88 J/g; and Gel time @ 170°C, 19 sec.
The resin was dissolved in toluene (20.0g resin/15mL toluene) and cured via the following cure cycle: 2 hours at 80°C, 16 hours at 100°C, 4 hours at 120°C, 16 hours at 160°C, 2 hours at, 200°C and 1 hour at 225°C. The cured polymer possessed the following properties a shown in Table 13.

**Table 13**

| $Tg(^{o}C)^{a}$ DSC | $Tsp(^{o}C)^{b}$ TMA | $\alpha_g$ [e] (ppm/°C) | $\alpha_{260}$ [f] (ppm/°C) | ε'/tanδ [e] 0%RH [f] | 50%RH | $H2O^{g}$ absorption (wt%) |
|---|---|---|---|---|---|---|
| 300 | 149 | 62 | 111 | 2.61/0.004 | 2.62/0.021 | 0.071 |

a. Glass transition temperature.
b. Softening point.
c. Coefficient of thermal expansion from 25°C to $T_{sp}$.
d. Coefficient of thermal expansion from 25°C to 260°C
e. ε' is the dielectric constant, tanδ the dissipation factor, measured at 1 MHz, 25°C, two-fluid cell.
f. Relative humidity.
g. Weight gain after two weeks at 50% relative humidity.

EXAMPLE IX

*Copolymers of STCDPF (70VB$_z$/30Pr) and styrene terminated bromo-substituted tetrakisphenol ethane (STBTPE) [70VB$_z$/30 PR].* Mixtures of STCDPF of Example I and STBTPE (70VB$_z$/30 Pr) were prepared. Blends of these thermosetting resins were cured as described in the preceding example using

toluene as the solvent. Analysis of the copolymer resulting from these blends disclose the following properties as collated in Table 14 below.

**Table 14**

| STBCDP wt(g) | STBTPE wt(g) | Tg($^{0}$C)[a] DSC | Tsp($^{o}$C)[b] TMA | $\alpha_g$[e] (ppm/$^{o}$C) | $\alpha_{260}$[f] (ppm/$^{o}$C) | $\epsilon$'tan$\delta$[e] 0%RH[f] | $\epsilon$'tan$\delta$[e] 50%RH | $H_2O$[g] absorption (wt%) |
|---|---|---|---|---|---|---|---|---|
| 10.14 | 10.17 | >300 | 146 | 65 | 93 | 2.78 | 2.89 | --- |

a. Glass transition temperature.

b. Softening point.

c. Coefficient of thermal expansion from 25$^{o}$C to Tsp.

d. Coefficient of thermal expansion from 25$^{o}$C to 260$^{o}$C

e. $\epsilon$' is the dielectric constant, tan$\delta$ the dissipation factor, measured at 1 MHz, 25$^{o}$C, two-fluid cell.

f. Relative humidity.

g. Weight gain after two weeks at 50% relative humidity.

## Claims

1. A thermosetting resin comprising ethers of the adduct of a dicyclopentadiene and phenol or the condensation product of at least one aldehyde or ketone with said adduct, said adduct having essentially the formula

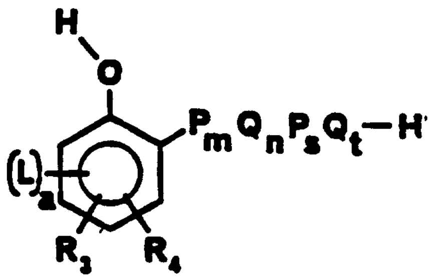

where

P = 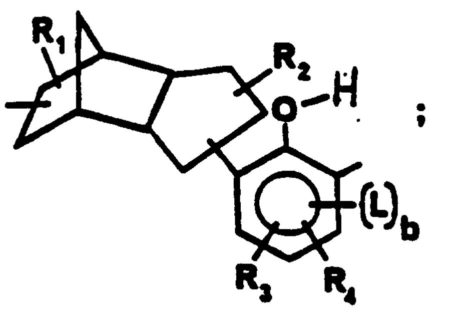 ; Q = 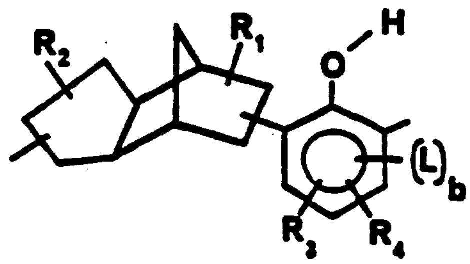

where $R_1$ and $R_2$ are independently selected from hydrogen or an alkyl moiety containing from 1 to 10 carbon atoms;

$R_3$ is selected from hydrogen, halogen, alkyl moieties containing from 1 to 20 carbon atoms, alkoxy or aryl, and is located at a position meta or para to the position of the oxygen on the aromatic ring;

$R_4$ Is hydrogen or a tertiary butyl moiety;

m, n, s, and t each are 0 or an Integer and whose sum is z, where z is 1-10;

a is 0, 1, or 2;

b is 0 or 1; and

L Is Cl or Br;

where the aldehyde or ketone is selected from formaldehyde, saturated aldehydes of formula $C_rH_{2r+1}CHO$, with r being an integer from 1 to 9, benzaldehydes, ketones of the formula. $CH_3COZ$, where Z is an alkyl group containing 1 to 4 carbons or an aryl group, and dialdehydes of formula $OHC-(CH_2)_xCHO$, where x is an integer from 2 to 8; and where at least 80% of the phenolic hydrogens are replaced by a moiety Y, where Y is selected from the vinylbenzyl moiety,

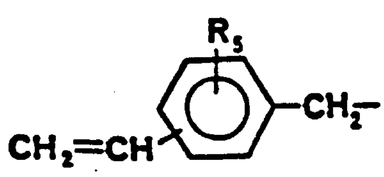

alkyl moieties containing 1 to 10 carbon atoms, cycloalkyl moieties having 5 to 10 carbon atoms, or benzyl, subject to the constraints a) at least 50% of all Y's are the vinylbenzyl moiety, b) the vinyl group is para or meta to the benzylic group, and c) $R_5$ is a chemically inert substituent selected from hydrogen, alkyl moieties containing from 1 to 10 carbon atoms, the halogens, alkoxy moieties containing from 1 to 10 carbon atoms, and monovalent aromatic hydrocarbon radicals.

2. The resin of Claim 1 where $R_1$ and $R_2$ are hydrogen.

3. The resin of Claim 1 where $R_3$ is a methyl, ethyl, propyl, or butyl group.

4. The resin of Claim 1 where $R_3$ is a methyl group.

5. The resin of Claim 1 where z is an integer from 1 to 5.

6. The resin of Claim 5 where z is 1 or 2.

7. The resin of Claim 1 where Y is a m- or p-vinylbenzyl moiety.

8. The resin of Claim 1 where $R_1$ and $R_2$ are lower alkyl groups from 1 to 4 carbon atoms.

9. The resin of Claim 1 where L is bromine.

10. The resin of Claim 1 where fewer than 5% of phenolic hydrogens remain and Y is a vinylbenzyl moiety or a linear alkyl moiety having 1 to 4 carbon atoms, with the ratio of the vinylbenzyl to alkyl moieties ranging from 1.1:1 to 6:1.

11. The resin of Claim 3 where at least 5 percent of all $R_4$ is a tertiary butyl moiety.

12. The resin of Claim 11 where up to 25 percent of all $R_4$ is a tertiary butyl moiety.

13. The resin of Claim 1 where $R_3$ is methyl, at least 5 and up to 25 percent of all R4 is a tertiary butyl moiety, fewer than 5% of phenolic hydrogens remain and Y is a vinylbenzyl moiety or linear alkyl moiety having 1 to 4 carbon atoms, with the ratio of vinylbenzyl to alkyl moieties ranging from 1.1:1 to 6:1.

14. The resin of Claim 1 where fewer than 20% of phenolic hydrogens remain and Y is the vinylbenzyl moiety.

15. The resin of Claim 1 where the aldehyde is formaldehyde.

16. The resin of Claim 1 where from 15 to 40% by weight of said adducts have z =1, from 10 to 30% by weight of said adducts have z = 2, from 5 to 20% by weight of said adducts have z = 3, from 5 to 20% by weight of said adducts have z = 4, and from 5 to 20% by weight of said adducts have z = 5-10.

## Patentansprüche

1. Wärmehärtbares Harz, das Äther des Addukts eines Dicyclopentadiens und eines Phenols oder das Kondensationsprodukt wenigstens eines Aldehyds oder Ketons mit diesem Addukt aufweist, welches Addukt im wesentlichen die Formel

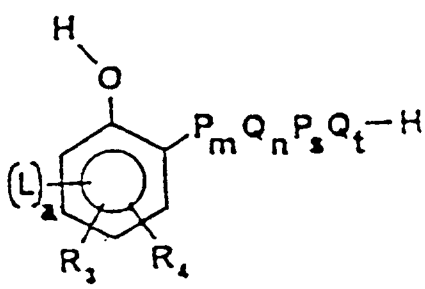

hat, worin

P = 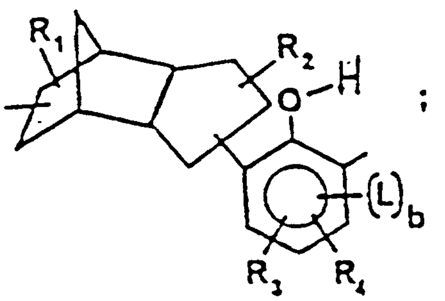 ; Q = 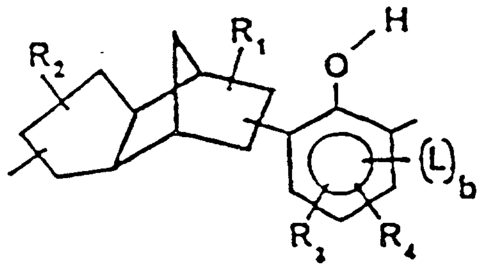

wobei $R_1$ und $R_2$ unabhängig voneinander aus Wasserstoff oder einer 1 bis 10 Kohlenstoffatome enthaltenden Alkylhälfte gewählt sind;

$R_3$ aus Wasserstoff, Halogen, 1 bis 20 Kohlenstoffatome enthaltenden Alkylhälften, Alkoxy- oder Arylgruppen gewählt ist und in meta- oder para-Stellung zur Stellung des Sauerstoffes am aromatischen Ring angeordnet ist;

$R_4$ Wasserstoff oder eine tertiäre Butylhälfte ist;

m, n, s und t jeweils 0 oder eine ganze Zahl bedeuten und deren Summe z beträgt, wobei z gleich 1-10 ist;

a gleich 0, 1 oder 2 ist;

b gleich 0 oder 1 ist; und

L gleich Cl oder Br ist;

wobei das Aldehyd oder das Keton aus Formaldehyd, gesättigten Aldehyden der Formel $C_rH_{2r+1}CHO$ gewählt sind, wobei r eine ganze Zahl von 1 bis 9 ist, aus Benzaldehyden, Ketonen der Formel $CH_3COZ$, worin Z eine 1 bis 4 Kohlenstoffe enthaltende Alkylgruppe oder eine Arylgruppe ist, sowie aus Dialdehyden der Formel $OHC(CH_2)_xCHO$, worin x eine ganze Zahl von 2 bis 8 ist; und wobei zumindest 80% der Phenol-Wasserstoffe durch eine Y-Hälfte ersetzt sind, wobei Y aus der Vinylbenzylhälfte

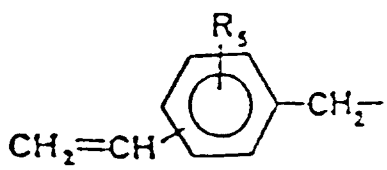

aus 1 bis 10 Kohlenstoffatome enthaltenden Alkylhälften, 5 bis 10 Kohlenstoffatome aufweisenden Cycloalkylhälften oder Benzylgruppen vorbehaltlich der Beschränkungen gewählt ist, daß a) zumindest 50% aller Y Vinylbenzylhälften sind, b) die Vinylgruppe zur Benzylgruppe in para- oder meta-Stellung steht, und c) $R_5$ ein chemisch inerter Substituent ist, der aus Wasserstoff, 1 bis 10 Kohlenstoffatome enthaltenden Alkylhälften, den Halogenen, 1 bis 10 Kohlenstoffatome enthaltenden Alkoxyhälften und einwertigen aromatischen Kohlenwasserstoffradikalen gewählt ist.

**2.** Harz nach Anspruch 1, bei dem $R_1$ und $R_2$ Wasserstoff sind.

**3.** Harz nach Anspruch 1, bei dem $R_3$ eine Methyl-, Äthyl-, Propyl- oder Butylgruppe ist.

**4.** Harz nach Anspruch 1, bei dem $R_3$ eine Methylgruppe ist.

**5.** Harz nach Anspruch 1, bei dem z eine ganze Zahl von 1 bis 5 ist.

**6.** Harz nach Anspruch 5, bei dem z gleich 1 oder 2 ist.

**7.** Harz nach Anspruch 1, bei dem Y eine m- oder p-Vinylbenzylhälfte ist.

**8.** Harz nach Anspruch 1, bei dem $R_1$ und $R_2$ niedrige Alkylgruppen mit 1 bis 4 Kohlenstoffatomen sind.

**9.** Harz nach Anspruch 1, bei dem L Brom ist.

**10.** Harz nach Anspruch 1, bei dem weniger als 5% der Phenol-Wasserstoffe verbleiben und Y eine Vinylbenzylhälfte oder eine lineare Alkylhälfte mit 1 bis 4 Kohlenstoffatomen ist, wobei das Verhältnis von Vinylbenzyl- zu Alkylhälften von1,1:1 bis 6:1 reicht.

**11.** Harz nach Anspruch 3, bei dem zumindest 5% aller $R_4$ eine tertiäre Butylhälfte sind.

**12.** Harz nach Anspruch 11, bei dem bis zu 25 Prozent aller $R_4$ eine tertiäre Butylhälfte sind.

**13.** Harz nach Anspruch 1, bei dem $R_3$ eine Methylgruppe ist, zumindest 5 und bis zu 25 Prozent aller $R_4$ eine tertiäre Butylhälfte sind, weniger als 5% der Phenol-Wasserstoffe verbleiben und Y eine Vinylbenzylhälfte oder eine lineare Alkylhälfte mit 1 bis 4 Kohlenstoffatomen ist, wobei das Verhältnis von Vinylbenzyl- zu Alkylhälften von1,1:1 bis 6:1 reicht.

**14.** Harz nach Anspruch 1, bei dem weniger als 20% der Phenol-Wasserstoffe verbleiben und Y die Vinylbenzylhälfte ist.

**15.** Harz nach Anspruch 1, bei dem das Aldehyd Formaldehyd ist.

**16.** Harz nach Anspruch 1, bei dem 15 bis 40 Gewichts-% der Addukte ein z = 1 aufweisen, 10 bis 30 Gewichts-% der Addukte ein z = 2 aufweisen, 5 bis 20 Gewichts-% der Addukte ein z = 3 aufweisen, 5 bis 20 Gewichts-% der Addukte ein z = 4 aufweisen und 5 bis 20 Gewichts-% der Addukte ein z = 5 - 10 aufweisen.

**Revendications**

**1.** Résine thermodurcissable composée d'éthersoxydes du produit d'addition d'un dicyclopentadiène et de phénol ou du produit de condensation d'au moins un aldéhyde ou une cétone avec ce produit d'addition, le produit d'addition ayant essentiellement pour formule,

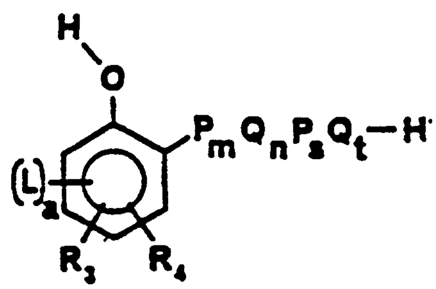

sachant que

P = 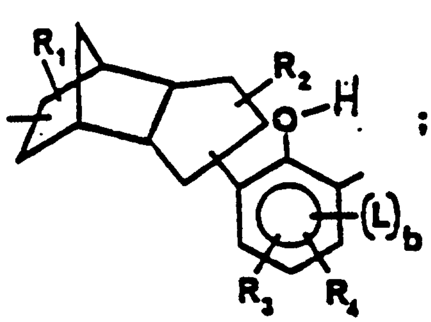 ; Q= 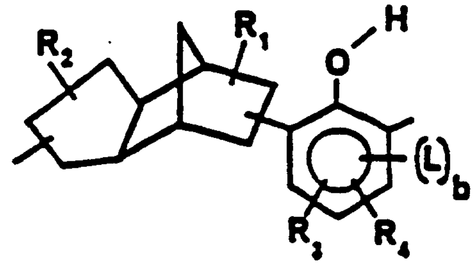

dans lesquelles:

- $R_1$ et $R_2$ sont indépendamments choisis parmi l'hydrogène ou un reste alkyle contenant de 1 à 10 atomes de carbone;
- $R_3$ est choisi parmi l'hydrogène, un halogène, des restes alkyle contenant de 1 à 20 atomes de carbone, un groupe alcoxy ou aryle, et se trouve en position méta ou para par rapport à l'atome de carbone portant l'oxygène sur le cycle aromatique;
- $R_4$ représente l'hydrogène ou un reste tertiobutyle;
- m, n, s et t représentent chacun 0 ou un nombre entier, et leur somme est égale à z, sachant que z est compris entre 1 et 10;
  a est égal à 0, 1 ou 2;
  b est égal à 0 ou 1; et
  L représente Cl ou Br;

sachant que l'aldéhyde ou la cétone est choisi parmi le formaldéhyde, des aldéhydes saturés répondant à la formule $C_rH_{2r+1}CHO$, r représentant un nombre entier compris entre 1 et 9, des benzaldéhydes, des cétones répondant à la formule $CH_3COZ$, dans laquelle Z représente un groupe alkyle contenant de 1 à 4 atomes de carbone ou un groupe aryle, et des dialdéhydes répondant à la formule $OHC(CH_2)_xCHO$, dans laquelle x représente un nombre entier compris entre 2 et 8; au moins 80% des hydrogènes phénoliques étant remplacés par un reste Y, Y étant choisi parmi le reste vinylbenzyle,

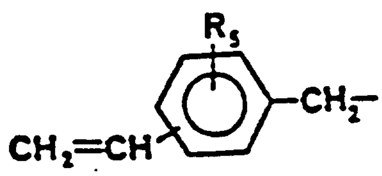

des restes alkyle contenant de 1 à 10 atomes de carbone, des restes cycloalkyle ayant de 5 à 10 atomes de carbone, ou benzyle, à condition que a) au moins 50% de l'ensemble des Y représente le reste vinylbenzyle, b) le groupe vinyle soit en para ou en méta par rapport au groupe benzylique, et c) $R_5$ représente un substituant inerte chimiquement choisi parmi l'hydrogène, des restes alkyle contenant de 1 à 10 atomes de carbone, les halogènes, des restes alcoxy contenant de l à 10 atomes de carbone, et des radicaux hydrocarbonés monovalents.

**2.** Résine selon la revendication 1, dans laquelle $R_1$ et $R_2$ représentent l'hydrogène.

**3.** Résine selon la revendication 1, dans laquelle $R_3$ représente un groupe méthyle, éthyle, propyle, ou butyle.

**4.** Résine selon la revendication 1, dans laquelle $R_3$ représente un groupe méthyle.

**5.** Résine selon la revendication 1, dans laquelle z représente un nombre entier compris entre 1 et 5.

**6.** Résine selon la revendication 5, dans laquelle z est égal à 1 ou à 2.

**7.** Résine selon la revendication 1, dans laquelle Y représente un reste m- ou p-vinylbenzyle.

**8.** Résine selon la revendication 1, dans laquelle $R_1$ et $R_2$ représentent des groupes alkyle inférieur ayant de 1 à 4 atomes de carbone.

**9.** Résine selon la revendication 1, dans laquelle L représente le brome.

**10.** Résine selon la revendication 1, dans laquelle il reste moins de 5% d'hydrogènes phénoliques et Y représente un reste vinylbenzyle ou un reste alkyle linéaire ayant de 1 à 4 atomes de carbone, le rapport des restes vinylbenzyle aux restes alkyle étant compris entre 1,1:1 et 6:1.

**11.** Résine selon la revendication 3, dans laquelle au moins 5 pourcent de l'ensemble des $R_4$ représente un reste tertiobutyle.

12. Résine selon la revendication 11, dans laquelle jusqu'à 25 pourcent de l'ensemble des $R_4$ représente un reste tertiobutyle.

13. Résine selon la revendication 1, dans laquelle $R_3$ représente un groupe méthyle, au moins 5 et jusqu'à 25 pourcent de l'ensemble des $R_4$ représente un reste tertiobutyle, il reste moins de 5% d'hydrogènes phénoliques et Y représente un reste vinylbenzyle ou un reste alkyle linéaire ayant de 1 à 4 atomes de carbone, le rapport des restes vinylbenzyle aux restes alkyle étant compris entre 1,1:1 et 6:1.

14. Résine selon la revendication 1, dans laquelle il reste moins de 20% d'hydrogènes phénoliques et Y représente le reste vinylbenzyle.

15. Résine selon la revendication 1, dans laquelle l'aldéhyde est le formaldéhyde.

16. Résine selon la revendication 1, dans laquelle de 15 à 40% en poids des produits d'addition ont z = 1, de 10 à 30% en poids des produits d'addition ont z = 2, de 5 à 20% en poids en poids des produits d'addition ont z = 3, de 5 à 20% en poids des produits d'addition ont z = 4, et de 5 à 20% en poids des produits d'addition ont z = 5-10.